# EUROPEAN PATENT APPLICATION

(11) **EP 4 704 536 A1**
(43) Date of publication of application: **04.03.2026**
(21) Application number: 24737856.5
(22) Date of filing: 05.06.2024
(51) Int. Cl.: H10K 59/131

(54) **DISPLAY PANEL AND DISPLAY APPARATUS**

(30) Priority: 23.05.2024 CN 202410654074
(71) Applicant: Wuhan China Star Optoelectronics Semiconductor Display Technology Co., Ltd., Wuhan, Hubei 430079 (CN)
(72) Inventor: CHEN, Tao, Wuhan, Hubei 430079 (CN)
(74) Representative: Herrero & Asociados, S.L.
(86) International application number: PCT/CN2024/097607
(87) International publication number: WO 2025/241227

(57) **Abstract**

The present application provides a display panel and a display device. A first conductive layer includes a plurality of data lines located in a display region. A second conductive layer is located at a side of the first conductive layer and includes a plurality of first fanout sections across more than one of the plurality of data lines located in the display region. One of the first fanout sections is connected to a corresponding one of the data lines. A third conductive layer is disposed between the first conductive layer and the second conductive layer and includes a shield portion. An overlapping portion between one of the first fanout sections and a corresponding one of the data lines insulated from and across the first fanout section overlaps the shield portion.

## Description

### TECHNICAL FIELD

The present application relates to a technical field of display, and more particularly, to a display panel and a display device.

### BACKGROUND

The Fanout in AA (FIAA) technology is an important technology for realizing a lower narrow frame of a display panel. The principle of the FIAA technique is to place part of the fanout wiring in a display region of the display panel to reduce the area of the non-display region occupied by the fanout wiring. Currently, for the display panel with the FIAA technology, the display panel may have a problem of degraded display during display.

Therefore, a technical solution is required to solve the problem of degraded display of the display panel with the FIAA technology.

### SUMMARY

The present application provides a display panel and a display device to improve degraded display of the display panel and the display device.

In a first aspect, an embodiment of the present application provides a display panel. The display panel has a display region, and the display panel includes: a substrate; a first conductive layer disposed above the substrate and including a plurality of data lines located in the display region; a second conductive layer disposed above the substrate, located at a side of the first conductive layer, and including a plurality of first fanout sections located in the display region, where more than one of the plurality of first fanout sections cross more than one of the plurality of data lines, respectively, and one of the first fanout sections is connected to a corresponding one of the data lines; and a third conductive layer disposed between the first conductive layer and the second conductive layer and including a shield portion, where an overlapping portion between one of the first fanout sections and a corresponding one of the data lines insulated from and across the first fanout section overlaps the shield portion.

In a second aspect, some embodiments of the present application provide a display device including a display panel of any of the above-described embodiments.

### BENEFICIAL EFFECTS

In the display panel and display device according to some embodiments of the present application, a first conductive layer includes a plurality of data lines located in a display region. A second conductive layer includes a plurality of first fanout sections located in the display region. A third conductive layer is disposed between the first conductive layer and the second conductive layer and includes a shield portion. More than one of the plurality of first fanout sections cross more than one of the plurality of data lines, respectively, and one of the first fanout sections is connected to a corresponding one of the data lines. An overlapping portion between one of the first fanout sections and a corresponding one of the data lines insulated from and across the first fanout section overlaps the shield portion. In this way, the shield portion acts as a shield between one first fanout line and at least one data line which are insulated and intersected with each other, thereby improving the crosstalk of the data signal due to a parasitic capacitance formed between one first fanout line and at least one data line which are insulated and intersected with each other, and improving the degraded display of the display panel and the display device due to the crosstalk of the data signal.

### BRIEF DESCRIPTION OF THE DRAWINGS

FIG. 1 is a schematic plan view of a display panel according to some embodiments of the present application.
FIG. 2 is a cross-sectional view taken along a line A-A of a display panel in FIG. 1.
FIG. 3 is a schematic view of a pixel circuit of a display panel according to some embodiments of the present application.
FIG. 4A is a schematic plan view of a first semiconductor layer of FIG. 2.
FIG. 4B is a schematic plan view of a fourth conductive layer of FIG. 2.
FIG. 4C is a schematic plan view of a sixth conductive layer of FIG. 2.
FIG. 4D is a schematic plan view of a second semiconductor layer of FIG. 2.
FIG. 4E is a schematic plan view of a fifth conductive layer of FIG. 2.
FIG. 4F is a schematic plan view of a second conductive layer of FIG. 2.
FIG. 4G is a schematic plan view of a third conductive layer of FIG. 2.
FIG. 4H is a schematic plan view of a first conductive layer of FIG. 2.
FIG. 5 is a schematic plan view of stacked film layers shown in FIGS. 4A to 4H.
FIG. 6 is a partial plan view of the first conductive layer, the second conductive layer, and the third conductive layer of FIG. 2 according to some embodiments of the present application.
FIG. 7 is a partial plan view of the second conductive layer, the fourth conductive layer, and the fifth conductive layer of FIG. 2 according to some embodiments of the present application.

### List of reference signs:

100, display panel; 100a, display region; 100b, non-display region;
11, 11a, 11b, data lines; 12, fanout line; 121, 121a, first fanout section; 122, second fanout section; 13, driver unit; 14, shield portion;
20, pixel circuit; T1, drive transistor; T2, write transistor; T4, initialization transistor; T3, compensation transistor; C, capacitor; T5, first light-emitting control transistor; T6, second light-emitting control transistor; T7, first reset transistor; T8, second reset transistor;
301, first scan signal line; 302, second scan signal line; 302a, second lower scan signal line; 302b, second upper scan signal line; 303, third scan signal line; 303a, third lower scan signal line; 303b, third upper scan signal line; 304, fourth scan signal line; 305, light-emitting control signal line; 306, first initialization signal line; 306a, first lower initialization signal line; 306b, first upper initialization signal line; 307, second initialization signal line; 308, third initialization signal line; 308a, third lower initialization signal line; 308b, third upper initialization signal line; 309, positive power supply voltage signal line; 3091, longitudinal body portion;
40, array layer; 401, first conductive layer; 402, second conductive layer; 403, third conductive layer; 404, fourth conductive layer; 405, fifth conductive layer; 406, sixth conductive layer;
407, first semiconductor layer; 4071, drive active layer; 4072, write active layer; 4073, first light-emitting active layer; 4074, second light-emitting active layer; 4075, first reset active layer; 4076, second reset active layer;
408, second semiconductor layer; 4081, initialization active layer; 4082, compensation active layer;
409, first insulation layer; 410, second insulation layer; 411, third insulation layer; 412, fourth insulation layer; 413, fifth insulation layer; 414, sixth insulation layer; 415, seventh insulation layer; 416, eighth insulation layer; 417, buffer layer;
50, light-emitting device layer; 51, light-emitting device; and 60, substrate.

### DETAILED DESCRIPTION

Technical solutions in embodiments of the present application will be clearly and completely described with reference to accompanying drawings in the embodiments of the present application. It will be apparent that the described embodiments are only part of the embodiments of the present application, and not all embodiments. Based on the embodiments in the present application, all other embodiments obtained by a person skilled in the art without involving any creative labor are within the scope of the present application.

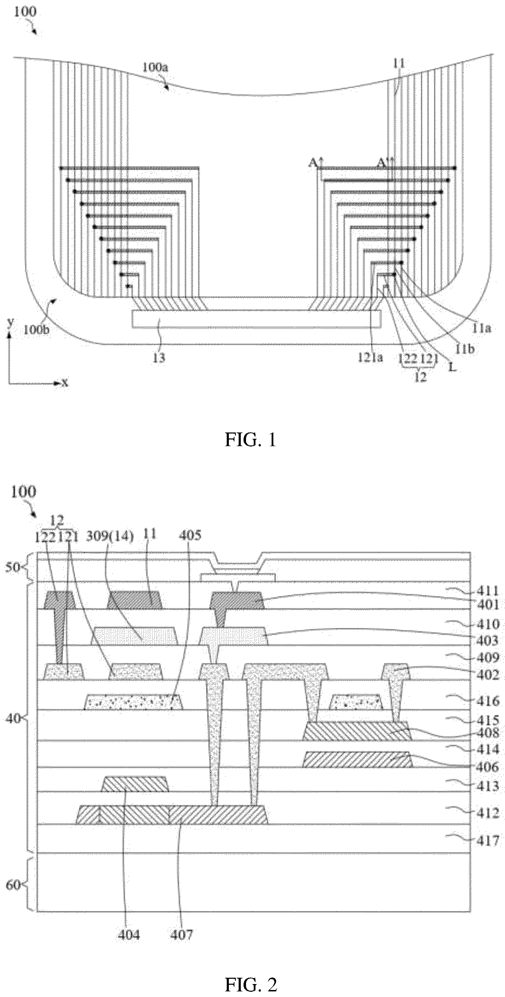

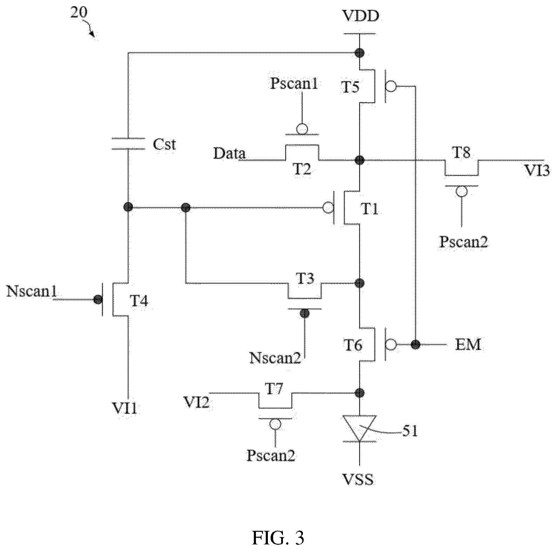

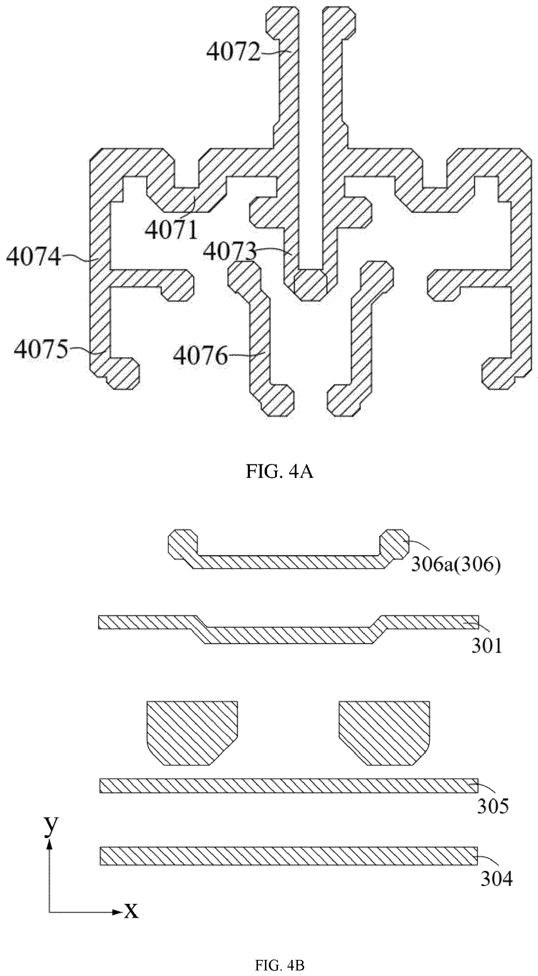

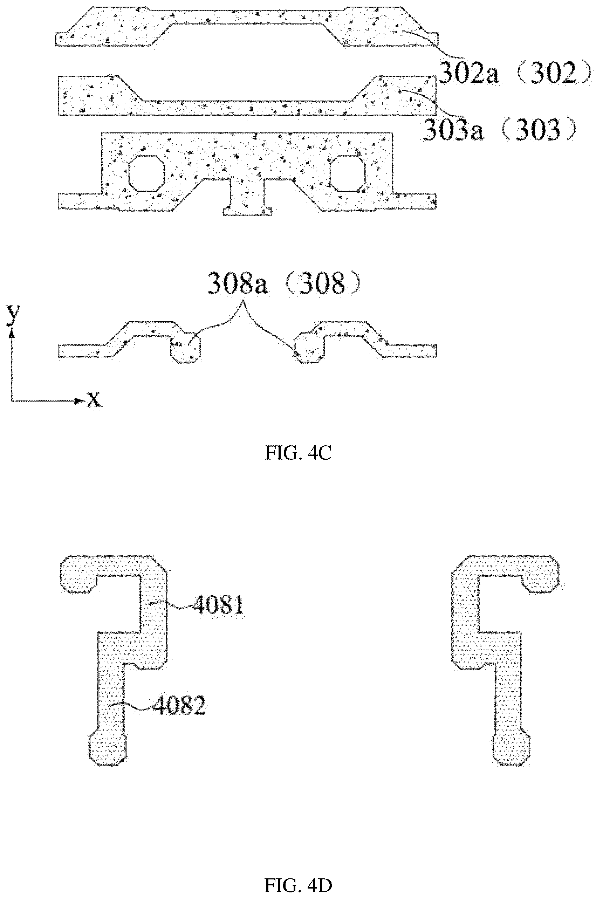

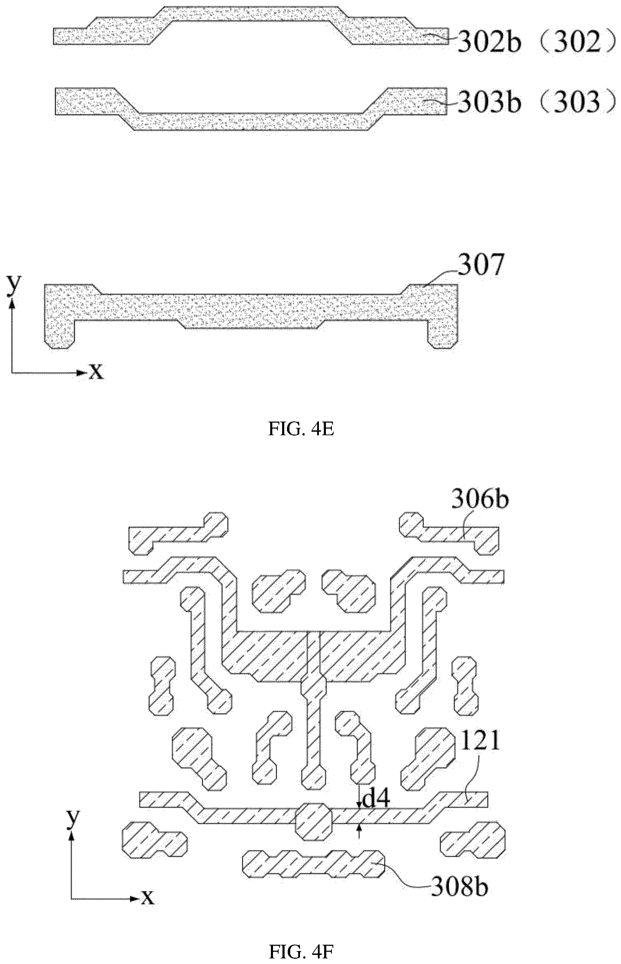

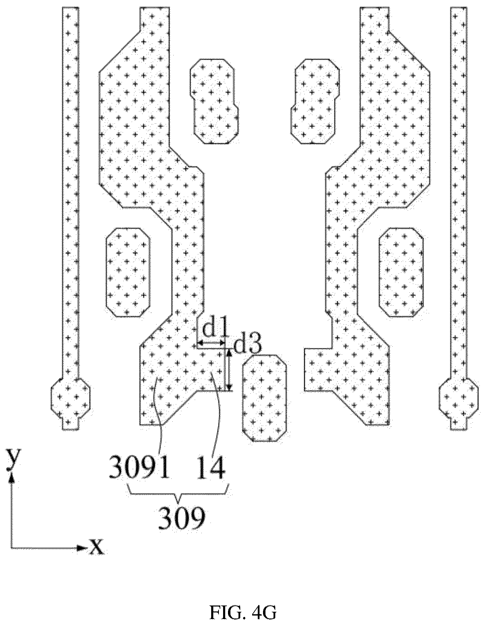

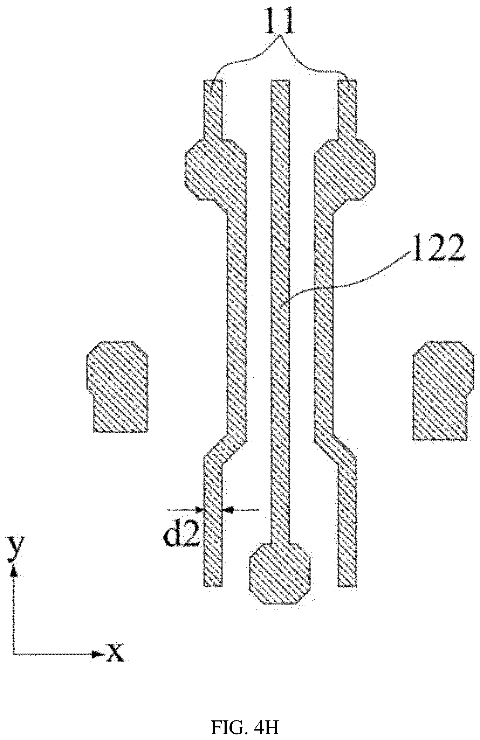

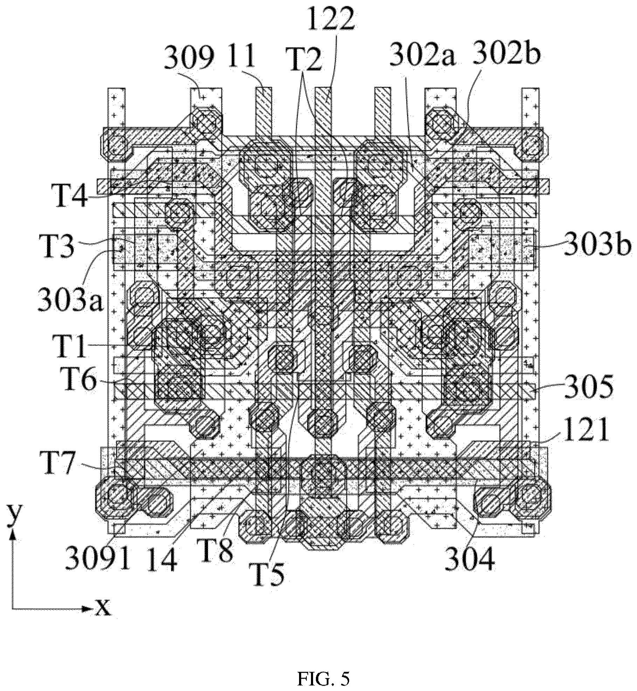

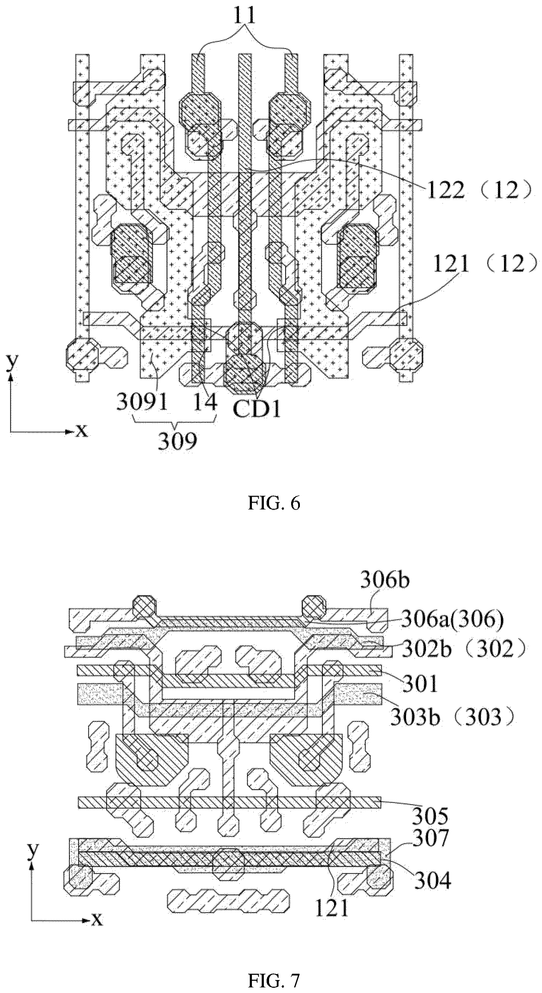

Referring to FIG. 1 to FIG. 3, FIG. 4A to FIG. 4H, and FIG. 5 to FIG. 7, FIG. 1 is a schematic plan view of a display panel according to some embodiments of the present application, FIG. 2 is a cross-sectional view taken along a line A-A of a display panel in FIG. 1, FIG. 3 is a schematic view of a pixel circuit of a display panel according to some embodiments of the present application, FIG. 4A is a schematic plan view of a first semiconductor layer of FIG. 2, FIG. 4B is a schematic plan view of a fourth conductive layer of FIG. 2, FIG. 4C is a schematic plan view of a sixth conductive layer of FIG. 2, FIG. 4D is a schematic plan view of a second semiconductor layer of FIG. 2, FIG. 4E is a schematic plan view of a fifth conductive layer of FIG. 2, FIG. 4F is a schematic plan view of a second conductive layer of FIG. 2, FIG. 4G is a schematic plan view of a third conductive layer of FIG. 2, FIG. 4H is a schematic plan view of a first conductive layer of FIG. 2, FIG. 5 is a schematic plan view of stacked film layers shown in FIGS. 4A to 4H, FIG. 6 is a partial plan view of the first conductive layer, the second conductive layer, and the third conductive layer of FIG. 2 according to some embodiments of the present application, FIG. 7 is a partial plan view of the second conductive layer, the fourth conductive layer, and the fifth conductive layer of FIG. 2 according to some embodiments of the present application.

As shown in FIG. 1, the display panel 100 includes a display region 100a and a non-display region 100b disposed around the display region 100a. The display panel 100 includes a plurality of data lines 11 located in the display region 100a and a plurality of fanout lines 12. Each of at least one of the fanout lines 12 is connected to a corresponding one of the data lines 11, and a black dot labeled by "L" in FIG. 1 means that the fanout line 12 is connected to the data line 11. The display panel 100 further includes a driver unit 13 disposed in the non-display region 100b, and the driver unit 13 may include a driver chip. The plurality of fanout lines 12 extend into the non-display region 100b and are connected to the driver unit 13. A data signal output by the driver unit 13 is transmitted to the corresponding data line 11 via the fanout line 12 connected with the data lines 11. In this way, a portion of the fanout lines 12 is disposed in the display region 100a, so that the area of the non-display region 100b occupied by the portion of the fanout lines 12 in the non-display region 100b may be reduced, and the size of the non-display region 100b of the display panel 100 may be advantageously reduced, thereby realizing a lower narrow frame of the display panel 100.

Each of at least one of the fanout lines 12 includes a first fanout section 121 located in the display region 100a and a second fanout section 122. The first fanout section 121 is connected to one of the data lines 11 and the second fanout section 122 is connected between the first fanout section 121 and the drive unit 13 and extends from the display region 100a to the non-display region 100b. The plurality of first fanout sections 121 respectively cross a plurality of data lines 11. Thus, each of the first fanout sections 121 is connected to a corresponding one of the data lines 11 and crosses and is insulated from other ones of the data lines 11. For example, the first fanout section 121a is connected to the data line 11a and crosses and is insulated from the data line 11b.

In some embodiments, the first fanout section 121 and the second fanout section 122 may include a linear segment, as shown in FIG. 1. Thus, the manufacturing process of the fanout line 12 may be simplified.

In some embodiments, the first fanout section 121 and the second fanout section 122 may include a fold line segment including at least two connected linear segments.

In other embodiments, the first fanout section 121 and the second fanout section 122 may include a curved segment.

In other embodiments, each of the first fanout section 121 and the second fanout section 122 may further include a plurality of linear segments. For example, the first fanout section 121 may include a body portion and a connection portion that connects two adjacent body portions. The plurality of body portions may be arranged along a first direction. The body portion includes two longitudinal segments extending in the first direction and one transverse segment extending in a second direction, one transverse segment connects the two longitudinal segments, and the first direction crosses the second direction, i.e., the body portion is in an I-shaped shape.

In some embodiments, the first fanout section 121 may extend in a first direction x, the second fanout section 122 may extend in a second direction y, and the first direction x crosses the second direction y. In some embodiments, the first direction x is perpendicular to the second direction y. It will be appreciated that an included angle between the first direction x and the second direction y may be an acute angle or an obtuse angle.

As shown in FIG. 2, the display panel 100 includes a substrate 60, an array layer 40, and a light emitting device layer 50. The array layer 40 is disposed on the substrate 60, and the light emitting device layer 50 is disposed at a side of the array layer 40 away from the substrate 60.

As shown in FIGS. 2 and 3, the array layer 40 includes a pixel circuit 20. The light-emitting device layer 50 includes a light-emitting device 51, which may be an organic light-emitting diode or an inorganic light-emitting diode. The pixel circuit 20 is connected to the light-emitting device 51 to control the light-emitting device 51 to emit light.

As shown in FIGS. 4B, 4C, and 4E to 4G, the display panel 100 further includes a positive power supply voltage signal line 309 (shown in FIG. 4G), a negative supply voltage signal line (not shown), a first initialization signal line 306 (shown in FIGS. 4B and 4F), a first scan signal line 301 (shown in FIG. 4B), a second scan signal line 302 (shown in FIGS. 4C and 4E), and a third scan signal line 303 (shown in FIGS. 4C and 4E), which are located in the array layer 40 and the light-emitting device layer 50 and connected to the pixel circuit 20. Here, the positive power supply voltage signal line 309 transmits a positive supply voltage signal VDD. The negative supply voltage signal line transmits a negative supply voltage signal VSS. The first initialization signal line 306 transmits a first initialization signal VII. The first scan signal line 301 transmits a first scan signal Pscan1. The second scan signal line 302 transmits a second scan signal Nscan1. The third scan signal line 303 transmits a third scan signal Nscan2.

In some embodiments, as shown in FIG. 3, the pixel circuit 20 includes a drive transistor T1, a write transistor T2, an initialization transistor T4, a compensation transistor T3, and a capacitor Cst.

In some embodiments, the initialization transistor T4 and the compensation transistor T3 may both be n-type transistors, and the drive transistor T1 and the write transistor T2 may both be p-type transistors.

In some embodiments, the initialization transistor T4 and the compensation transistor T3 may both be metal oxide transistors, and the drive transistor T1 and the write transistor T2 may both be low temperature polysilicon transistors. In this way, the leakage currents of the initialization transistor T4 and the compensation transistor T3 may be reduced, and the flicker of the display panel 100 in the low-frequency display may be improved.

In other embodiments, the drive transistor T1, the write transistor T2, the initialization transistor T4, and the compensation transistor T3 may all be low temperature polysilicon transistors.

The current generated when the drive transistor T1 is turned on drives the light-emitting device 51 to emit light.

A source and a drain of the write transistor T2 are connected between the data line 11 and one of a source and a drain of the drive transistor T1, and a gate of the write transistor T2 is connected to the first scan signal line 301. Thus, when the write transistor T2 is turned on in response to the first scan signal Pscan1 transmitted by the first scan signal line 301, the data signal Data transmitted by the data line 11 may be transmitted to one of the source and the drain of the drive transistor T1.

A source and a drain of the initialization transistor T4 are connected between a first initialization signal line 306 and a gate of the drive transistor T1, and a gate of the initialization transistor T4 is connected to the second scan signal line 302. Thus, when the initialization transistor T4 is turned on in response to the second scan signal Nscan1 transmitted by the second scan signal line 302, the first initialization signal VI1 transmitted by the first initialization signal line 306 may be transmitted to the gate of the drive transistor T1 to initialize the potential of the gate of the drive transistor T1.

The compensation transistor T3 is connected between the gate of the drive transistor T1 and the other of the source and the drain of the drive transistor T1, and a gate of the compensation transistor T3 is connected to the third scan signal line 303. Thus, when the compensation transistor T3 is turned on in response to the third scan signal Nscan2 transmitted by the third scan signal line 303, the gate of the drive transistor T1 is connected to the other of the source and the drain of the drive transistor T1.

Two plates of the capacitor Cst are connected to the positive power supply voltage signal line 309 and the gate of the drive transistor T1, respectively.

In some embodiments, as shown in FIG. 3, the pixel circuit 20 may further include a first light-emitting control transistor T5 and a second light-emitting control transistor T6. Each of the first light-emitting control transistor T5 and the second light-emitting control transistor T6 may be P-type low-temperature polysilicon transistors. As shown in FIGS. 4B and 5, the display panel 100 may further include a light-emitting control signal line 305 that transmits a light-emitting control signal EM. A source and a drain of the first light-emitting control transistor T5 are connected between the positive power supply voltage signal line 309 and one of the source and the drain of the drive transistor T1. A source and a drain of the second light-emitting control transistor T6 are connected between the light-emitting device 51 and the other of the source and the drain of the drive transistor T1, and a gate of the write transistor T2 is connected to the first scan signal line 301. A gate of the first light-emitting control transistor T5 and a gate of the second light-emitting control transistor T6 are both connected to the light-emitting control signal line 305.

In some embodiments, the pixel circuit 20 may further include a first reset transistor T7. The first reset transistor T7 functions as a reset to the anode of the light-emitting device 51. As shown in FIGS. 4B, 4E, and 5, the display panel 100 further includes a fourth scan signal line 304 transmitting a fourth scan signal Pscan2 and a second initialization signal line 307 transmitting a second initialization signal VI2. One of a source and a drain of the first reset transistor T7 is connected to the second initialization signal line 307, the other of the source and the drain of the first reset transistor T7 is connected between the light-emitting device 51 and the other of the source and the drain of the drive transistor T1, and a gate of the first reset transistor T7 is connected to the fourth scan signal line 304.

In some embodiments, the second initialization signal line 307 and the first initialization signal line 306 may be different signal lines. As such, the first reset transistor T7 and the initialization transistor T4 may be independently controlled.

In other embodiments, the second initialization signal line 307 and the first initialization signal line 306 may be the same signal line, i.e., the second initialization signal line 307 and the first initialization signal line 306 are the identical signal line. Thus, the process of the pixel circuit 20 may be simplified.

In some embodiments, the pixel circuit 20 further includes a second reset transistor T8. The second reset transistor T8 initializes the potential of one of the source and drain electrodes of the drive transistor T1 to improve the display effect of the display panel 100 in the low-frequency display process. As shown in FIGS. 4C and 4F, the display panel 100 further includes a third initialization signal line 308, which transmits the third initialization signal VI3. A source and a drain of the second reset transistor T8 are connected between the third initialization signal line 308 and one of the source and drain of the drive transistor T1, and a gate of the second reset transistor T8 is connected to the fourth scan signal line 304. Thus, both the first reset transistor T7 and the second reset transistor T8 are controlled by the fourth scan signal Pscan2 transmitted from the fourth scan signal line 304.

In some embodiments, each of the first reset transistor T7 and the second reset transistor T8 may be a p-type low temperature polysilicon transistor.

The pixel circuit 20 shown in FIG. 3 includes eight transistors and a capacitor to ensure the good display effect of the display panel 100 at high and low frequencies.

The array layer 40 includes a conductive layer, an insulation layer, and a semiconductor layer in which portions of the pixel circuit 20 are located.

As shown in FIG. 2, in some embodiments, the array layer 40 includes a first conductive layer 401, a second conductive layer 402, and a third conductive layer 403. Each of the first conductive layer 401 to the third conductive layer 403 may include a metal.

As shown in FIGS. 2 and 4H, the first conductive layer 401 is disposed above the substrate 60 and includes the plurality of data lines 11 disposed spaced apart from each other in the display region 100a.

As shown in FIGS. 2 and 4F, the second conductive layer 402 is disposed above the substrate 60 at a side of the first conductive layer 401 and includes the plurality of first fanout sections 121 disposed spaced apart from each other in the display region 100a. Any one of the first fanout sections 121 is connected to a corresponding one of the data lines 11 through a via through the insulation layer so that the fanout line 12 is connected to the data line 11.

As shown in FIG. 2, the third conductive layer 403 is disposed between the first conductive layer 401 and the second conductive layer 402, and includes a shield portion 14. As shown in FIG. 6, an overlapping portion (a portion denoted by the dashed line box CD1 in FIG. 6) between a first fanout sections 121 and at least one data line 11 insulated from and across the first fanout section 121 overlaps the shield portion 14. As described above, the shield portion 14 functions as a shield between the first fanout line 12 and the at least one data line 11 which is insulated from and crosses the first fanout line 12, thereby improving the crosstalk of the data signal caused by a parasitic capacitance formed between the first fanout line 12 and the at least one data line 11, and improving the degraded display of the display panel 100 due to the crosstalk of the data signal.

It should be noted that, when the first fanout section 121 overlaps the at least one data line 11 insulated from and across the first fanout section 121, an orthographic projection of the first fanout section 121 on the substrate 60 overlaps an orthographic projection of the at least one data line 11 on the substrate 60. When the overlapping portion between the first fanout section 121 and the at least one data line 11, which is insulated from and crosses the first fanout section 121, overlaps with the shield portion 14, an orthographic projection of the overlapping portion CD1 on the substrate 60 overlaps with an orthographic projection of the shield portion 14 on the substrate 60. The direction of the orthographic projection is a direction from the first conductive layer 401 towards the substrate 60.

It should also be noted that in the related art, when one first fanout section overlaps at least one data line insulated from and across the one first fanout section 121, the data signal transmitted by the first fanout section transitions, and the transitions cause the data signal transmitted by the data line in the floating state to cross-talk due to the parasitic capacitance between the data line and the first fanout section, thereby causing the degraded display.

In some embodiments, as shown in FIG. 6, an orthographic projection of the overlapping portion between a first fanout section 121 and at least one data line 11, that is insulated from and crosses the first fanout section 121, on the substrate 60 is located within an orthographic projection of the shield portion 14 on the substrate 60. In this way, the data crosstalk caused by the parasitic capacitance between the first fanout section 121 and the at least one data line 11 that are insulated and intersected with each other may be better improved, and the display effect of the display panel 100 may be improved.

In some embodiments, the display panel 100 includes a direct current (DC) signal line such as a positive power supply voltage signal line 309 and a negative supply voltage signal line, and the direct current signal line may include the shield portion 14. In this way, at least part of the DC signal line for transmitting the DC signal functions as a shield portion 14 to provide a shielding function. Further, since at least a portion of the direct current signal line in the display panel 100 is used as the shielding portion 14, an additional shielding portion 14 does not need to be additionally provided, so that the manufacturing process of the display panel 100 is simplified while improving the degraded display of the display panel 100 due to the crosstalk of the data signal.

In some embodiments, as shown in FIGS. 2 and 4G and FIG. 6, the positive power supply voltage signal line 309 includes a shield portion 14. This simplifies the manufacturing process of the display panel 100 by using the positive power supply voltage signal line 309 in the display panel 100 as the shield portion 14. In the case where the shield portion 14 is included in the positive power supply voltage signal line 309, the positive power supply voltage signal line 309 is located at the third conductive layer 403.

It should be noted that when the positive power supply voltage signal line 309 is located in the third conductive layer 403, the positive power supply voltage signal line 309 may be disposed in the entire display region 100a, and it is more easily realized to use at least part of the positive power supply voltage signal line 309 as the shield portion 14.

In some embodiments, as shown in FIG. 4G, FIG. 5, and FIG. 6, the positive power supply voltage signal line 309 includes a longitudinal body portion 3091 and a shield portion 14 which are connected to each other. The longitudinal body portion 3091 extends in a same direction (second direction y) as the data line 11. The longitudinal body portion 3091 is offset from the data line 11. The shield portion 14 extends in the same direction (first direction x crosses the second direction y) as the first fanout section 121. Thus, the shield portion 14 extends in a direction across that of the longitudinal body portion 3091, and the shield portion 14 is a part of the positive power supply voltage signal line 309 extending from the longitudinal body portion 3091.

It should be noted that, as shown in FIGS. 5 and 6, that the longitudinal body portion 3091 is offset from the data line 11 means that an orthographic projection of the longitudinal body portion 3091 on the substrate 60 does not overlap with an orthographic projection of the data line 11 on the substrate 60.

In some embodiments, as shown in FIG. 4G, the shield portion 14 may have a rectangular shape. Thus, the manufacturing process of the shield portion 14 may be simplified. In other embodiments, the shield portion 14 may have a non-irregular shape.

In some embodiments, as shown in FIGS. 4F to 4H and FIG. 6, the size d1 of the shield portion 14 in the first direction x may be greater than the size d2 of the data line 11 in the first direction x, and the size d3 of the shield portion 14 in the second direction may be greater than the size d4 of the first fanout section 121 in the second direction y. In this way, the area of the shield portion 14 is greater than an area of an overlapping portion where the data line 11 overlaps the first fanout section 121.

In other embodiments, in the case that the longitudinal body portion 3091 overlaps one of the data lines 11, a portion of the longitudinal body portion 3091 may be used as the shield portion 14. At this time, the size of the longitudinal body portion 3091 in the width direction (e.g., the first direction x) of the data line 11 may be greater than the width of the data line 11.

In some embodiments, the positive power supply voltage signal line 309 may further include a lateral body portion (not shown) extending in the first direction x, and the lateral body portion connects adjacent longitudinal body portions 3091. Thus, the positive power supply voltage signal line 309 has a grid shape to reduce the resistance voltage drop of the positive power supply voltage signal line 309 and improve the uniformity of the impedance of the positive power supply voltage signal line 309 in different regions.

In other embodiments, in the case that the transverse body portion overlaps the first fanout section 121, and at least part of the transverse body portion may be used as the shield portion 14. At this time, the size of the transverse body portion in the width direction (e.g., the second direction y) of the first fanout section 121 may be greater than the width of the first fanout section 121.

In other embodiments, at least one of the first initialization signal line 306, the second initialization signal line 307, and the third initialization signal line 308 may include a shield portion 14. In this manner, at least part of one of the first initialization signal lines 306 to the third initialization signal lines 308 for transmitting the constant voltage signal may be used as the shield portion 14. At this time, at least one of the first initialization signal line 306, the second initialization signal line 307, and the third initialization signal line 308 is located in the third conductive layer 403. In a particular embodiment, the direct current signal line may include a first initialization signal line 306. For example, any one of the first initialization signal line 306, the second initialization signal line 307, and the third initialization signal line 308 may include the shield portion 14.

Note that the first initialization signal line 306 to the third initialization signal line 308 may extend in a direction same as that of the first fanout section 121. In the case where at least part of one of the first initialization signal line 306 to the third initialization signal line 308 is used as the shield portion 14, an orthographic projection of the first fanout section 121 on the substrate 60 may be located in an orthographic projection of one of the first initialization signal line 306 to the third initialization signal line 308 on the substrate 60.

In some embodiments, as shown in FIG. 2, the first conductive layer 401 is located on a side of the second conductive layer 402 away from the substrate 60. As described above, it is possible to increase the spacing between the data line 11 and other conductive layers (conductive layers between the first conductive layer 401 and the substrate 60) under the first conductive layer 401, to reduce a parasitic capacitance between the data line 11 and the signal lines in the other conductive layers, and to further improve the crosstalk of the data signal for the data line 11 generated by the parasitic capacitance, thereby improving the degraded display of the display panel 100 due to the crosstalk of the data signal.

In some embodiments, the plurality of second fanout sections 122 may be located at a different conductive layer from the plurality of first fanout sections 121. For example, the first conductive layer 401 further includes a plurality of second fanout sections 122 spaced apart from the plurality of data lines 11, i.e., the plurality of data lines 11 are disposed at the same level as the plurality of second fanout sections 122. In the case that the first conductive layer 401 is located at the side of the second conductive layer 402 away from the substrate 60, the parasitic capacitance between the second fanout section 122 and other signal lines may be reduced, to further improve the crosstalk of the data signal for the second fanout section 122 caused by the parasitic capacitance, thereby improving the degraded display of the display panel 100 due to the crosstalk of the data signal.

In other embodiments, the plurality of second fanout sections 122 may be located in the same conductive layer as the plurality of first fanout sections 121. For example, the second conductive layer 402 may include the plurality of second fanout sections 122. Thus, the connection between the first fanout section 121 and the second fanout section 122 becomes simpler.

In some embodiments, as shown in FIG. 2, the array layer 40 includes a first insulation layer 409 and a second insulation layer 410. The first insulation layer 409 is disposed between the second conductive layer 402 and the third conductive layer 403. The second insulation layer 410 is disposed between the third conductive layer 403 and the first conductive layer 401.

In some embodiments, as shown in FIG. 2, the array layer 40 further includes a third insulation layer 411. The third insulation layer 411 is disposed between the first conductive layer 401 and the light-emitting device layer 50.

In some embodiments, the first insulation layer 409, the second insulation layer 410, and the third insulation layer 411 may all be organic insulation layers. In this way, the distance between two adjacent ones of the first conductive layer 401 to the third conductive layer 403 and the light-emitting device layer 50 may be increased, to reduce the parasitic capacitance, and the three insulation layers may perform a good planarization function, thereby improving the light-emitting effect of the light-emitting device of the light-emitting device layer 50.

In some embodiments, as shown in FIGS. 2, 4A, and 4D, the display panel 100 further includes a first semiconductor layer 407 and a second semiconductor layer 408.

As shown in FIG. 2, the first semiconductor layer 407 is disposed between the second conductive layer 402 and the substrate 60 and between the first conductive layer 401 and the substrate 60, and includes polysilicon. A buffer layer 417 is disposed between the first semiconductor layer 407 and the substrate 60. The second semiconductor layer 408 is disposed between the second conductive layer 402 and the substrate 60 and between the first conductive layer 401 and the substrate 60, and is disposed at a side of the first semiconductor layer 407 away from the substrate 60, and includes a metal oxide including but not limited to indium gallium zinc oxide or the like. As such, the display panel 100 includes two different semiconductor layers.

In the case that the pixel circuit 20 includes a polysilicon transistor and a metal oxide transistor, the first semiconductor layer 407 includes an active layer of the polysilicon transistor, and the second semiconductor layer 408 includes an active layer of the metal oxide transistor.

Illustratively, as shown in FIGS. 4A and 5, the first semiconductor layer 407 may include a drive active layer 4071 of the drive transistor T1, a write active layer 4072 of the write transistor T2, a first light-emitting active layer 4073 of the first light-emitting control transistor T5, a second light-emitting active layer 4074 of the second light-emitting control transistor T6, a first reset active layer 4075 of the first reset transistor T7, and a second reset active layer 4076 of the second reset transistor T8. As shown in FIGS. 4D and 5, the second semiconductor layer 408 may include an initialization active layer 4081 of the initialization transistor T4 and a compensation active layer 4082 of the compensation transistor T3.

In some embodiments, as shown in FIG. 2, the array layer 40 further includes a fourth conductive layer 404 and a fifth conductive layer 405.

The fourth conductive layer 404 is disposed between the second conductive layer 402 and the substrate 60. As shown in FIG. 4B, the fourth conductive layer 404 includes a scan line including at least one of the first scan signal line 301 to the fourth scan signal line 304 and the light-emitting control signal line 305.

Illustratively, as shown in FIG. 4B, the fourth conductive layer 404 includes a first scan signal line 301, a fourth scan signal line 304, and a light-emitting control signal line 305 arranged spaced apart from each other. The first scan signal line 301, the fourth scan signal line 304, and the light-emitting control signal line 305 all extend in the first direction x. As shown in FIG. 5, the first scan signal line 301 overlaps the write active layer 4072 of the write transistor T2. The fourth scan signal line 304 overlaps the first reset active layer 4075 of the first reset transistor T7 and the second reset active layer 4076 of the second reset transistor T8. The light-emitting control signal line 305 overlaps the first light-emitting active layer 4073 of the first light-emitting control transistor T5 and the second light-emitting active layer 4074 of the second light-emitting control transistor T6.

The fifth conductive layer 405 is disposed between the fourth conductive layer 404 and the second conductive layer 402 and includes an initialization signal line including at least one of the first initialization signal line 306 to the third initialization signal line 308. Illustratively, as shown in FIG. 4E, the fifth conductive layer 405 includes a second initialization signal line 307.

In some embodiments, the scan line of the fourth conductive layer 404 overlaps the first fanout section 121, and the overlapping portion between the scan line of the fourth conductive layer 404 and the first fanout section 121 overlaps the initialization signal line of the fifth conductive layer 405. Illustratively, as shown in FIG. 7, an overlapping portion between the fourth scan signal line 304 and the first fanout section 121 overlaps the second initialization signal line 307. In this manner, the second initialization signal line 307 functions as a shield to improve the signal crosstalk caused by the parasitic capacitance between the fourth scan signal line 304 and the first fanout section 121, and to improve the degraded display due to signal crosstalk.

In some embodiments, as shown in FIG. 2, the array layer 40 further includes a sixth conductive layer 406. The sixth conductive layer 406 is located between the fourth conductive layer 404 and the fifth conductive layer 405. As shown in FIG. 4C, the sixth conductive layer 406 may include a third initialization signal line 308, a second scan signal line 302, and a third scan signal line 303 disposed spaced apart from each other.

Illustratively, as shown in FIG. 2, the fourth conductive layer 404 is located at a side of the first semiconductor layer 407 away from the substrate 60. A fourth insulation layer 412 is disposed between the fourth conductive layer 404 and the first semiconductor layer 407. The sixth conductive layer 406 is located at a side of the fourth conductive layer 404 away from the substrate 60. A fifth insulation layer 413 is disposed between the sixth conductive layer 406 and the fourth conductive layer 404. The sixth conductive layer 406 is disposed between the second semiconductor layer 408 and the fourth conductive layer 404, and a sixth insulation layer 414 is disposed between the sixth conductive layer 406 and the second semiconductor layer 408. A fifth conductive layer 405 is disposed between the second semiconductor layer 408 and the second conductive layer 402, and a seventh insulation layer 415 is disposed between the fifth conductive layer 405 and the second semiconductor layer 408. An eighth insulation layer 416 is disposed between the fifth conductive layer 405 and the second conductive layer 402.

In some embodiments, as shown in FIGS. 4B and 4F, the first initialization signal line 306 may include a first lower initialization signal line 306a located in the fourth conductive layer 404 and a first upper initialization signal line 306b located in the second conductive layer 402. The first lower initialization signal line 306a and the first upper initialization signal line 306b are connected through a via located in the insulation layer.

In some embodiments, as shown in FIGS. 4C and 4F, the third initialization signal line 308 may include a third lower initialization signal line 308a located in the sixth conductive layer 406 and a third upper initialization signal line 308b located in the second conductive layer 402. The third lower initialization signal line 308a and the third upper initialization signal line 308b are connected through a via located in the insulation layer.

In some embodiments, as shown in FIGS. 4C and 4E, the second scan signal line 302 includes a second lower scan signal line 302a located in the sixth conductive layer 406 and a second upper scan signal line 302b located in the fifth conductive layer 405. The second lower scan signal line 302a and the second upper scan signal line 302b are connected through a via located in the insulation layer. As shown in FIG. 5, the second lower scan signal line 302a and the second upper scan signal line 302b both overlap the initialization active layer 4081 of the initialization transistor T4.

In some embodiments, as shown in FIGS. 4C and 4E, the third scan signal line 303 includes a third lower scan signal line 303a located in the sixth conductive layer and a third upper scan signal line 303b located in the fifth conductive layer 405. The third lower scan signal line 303a and the third upper scan signal line 303b are connected through a via located in the insulation layer. As shown in FIG. 5, the third lower scan signal line 303a and the third upper scan signal line 303b both overlap the compensation active layer 4082 of the compensation transistor T3.

Based on the same inventive concept, some embodiments of the present application further provide a display device. The display device includes the display panel 100 in any of the embodiments described above.

In sum, according to the display panel and the display device in some embodiments of the present application, the shield portion functions as a shield between the first fanout line and the data line which is insulated from and crosses the first fanout line, thereby improving the crosstalk of the data signal caused by the parasitic capacitance formed between the first fanout line and the data line, and improving the degraded display of the display panel due to the crosstalk of the data signal.

The description of the above embodiments is merely intended to assist in understanding the technical solutions of the present application and the core concepts thereof. It will be appreciated by those of ordinary skill in the art that modifications may still be made to the technical solutions described in the foregoing embodiments, or equivalents may be made to some of the technical features therein. These modifications or substitutions do not depart the essence of the corresponding technical solutions from the scope of the technical solutions of the embodiments of the present application.

## Claims

1. A display panel, **characterized in that** the display panel has a display region, and the display panel includes:
a substrate;
a first conductive layer disposed above the substrate and including a plurality of data lines located in the display region;
a second conductive layer disposed above the substrate, located at a side of the first conductive layer, and including a plurality of first fanout sections located in the display region, wherein more than one of the plurality of first fanout sections cross more than one of the plurality of data lines, respectively, and one of the first fanout sections is connected to a corresponding one of the data lines; and
a third conductive layer disposed between the first conductive layer and the second conductive layer and including a shield portion,
wherein an overlapping portion between one of the first fanout sections and a corresponding one of the data lines insulated from and across the first fanout section overlaps the shield portion.

2. The display panel of claim 1, **characterized in that** the display panel further includes a direct current signal line including the shield portion.

3. The display panel of claim 2, **characterized in that** the direct current signal line includes a positive power supply voltage signal line.

4. The display panel of claim 3, **characterized in that** the positive power supply voltage signal line includes a longitudinal body portion and the shield portion connected with each other, the longitudinal body portion extends in a same direction as the data line, the longitudinal body portion is offset from the data line, and the shield portion extends in a same direction as the first fanout section.

5. The display panel of claim 1, **characterized in that** the display panel further includes:
a first initialization signal line, a second initialization signal line, and a third initialization signal line; and
a pixel circuit, wherein the pixel circuit includes:
a drive transistor;
a write transistor having a source and a drain connected between one of the data lines and one of a source and a drain of the drive transistor;
an initialization transistor having a source and a drain connected between the first initialization signal line and a gate of the drive transistor;
a light-emitting device connected to other of the source and the drain of the drive transistor;
a first reset transistor, wherein one of a source and a drain of the first reset transistor is connected to the second initialization signal line, other of the source and the drain of the first reset transistor is connected between the light-emitting device and the other of the source and the drain of the drive transistor; and
a second reset transistor, wherein a source and a drain of the second reset transistor are connected between the third initialization signal line and one of the source and drain of the drive transistor,
wherein at least one of the first initialization signal line, the second initialization signal line, and the third initialization signal line includes the shield portion.

6. The display panel of claim 1, **characterized in that** the first conductive layer is located at a side of the second conductive layer away from the substrate.

7. The display panel of claim 6, **characterized in that** the first conductive layer further includes a plurality of second fanout sections spaced apart from more than one of the plurality of the data lines, the plurality of second fanout sections extend in a direction across that of more than one of the plurality of first fanout sections, and one of the second fanout sections is connected to a corresponding one of the first fanout sections.

8. The display panel of claim 6, **characterized in that** the display panel further includes:
a fourth conductive layer disposed between the second conductive layer and the substrate and including a scan signal line; and
a fifth conductive layer disposed between the fourth conductive layer and the second conductive layer and including an initialization signal line;
wherein the scan signal line overlaps the first fanout section, and an overlapping portion between the scan signal line and the first fanout section overlaps the initialization signal line.

9. The display panel of claim 1, **characterized in that** the display panel further includes:
a first semiconductor layer disposed between the second conductive layer and the substrate and between the first conductive layer and the substrate and including polysilicon; and
a second semiconductor layer disposed between the second conductive layer and the substrate and between the first conductive layer and the substrate and located on a side of the first semiconductor layer away from the substrate and including a metal oxide.

10. A display device, **characterized in that** the display device includes a display panel having a display region, and the display panel includes:
a substrate;
a first conductive layer disposed above the substrate and including a plurality of data lines located in the display region;
a second conductive layer disposed above the substrate, located at a side of the first conductive layer, and including a plurality of first fanout sections located in the display region, wherein more than one of the plurality of first fanout sections cross more than one of the plurality of data lines, respectively, and one of the first fanout sections is connected to a corresponding one of the data lines; and
a third conductive layer disposed between the first conductive layer and the second conductive layer and including a shield portion,
wherein an overlapping portion between one of the first fanout sections and a corresponding one of the data lines insulated from and across the first fanout section overlaps the shield portion.

11. The display device of claim 10, wherein the display panel further includes a direct current signal line including the shield portion.

12. The display device of claim 11, wherein the direct current signal line includes a positive power supply voltage signal line.

13. The display device of claim 12, wherein the positive power supply voltage signal line includes a longitudinal body portion and the shield portion connected with each other, the longitudinal body portion extends in a same direction as the data line, the longitudinal body portion is offset from the data line, and the shield portion extends in a same direction as the first fanout section.

14. The display device of claim 10, wherein the display panel further includes:
a first initialization signal line, a second initialization signal line, and a third initialization signal line; and
a pixel circuit, wherein the pixel circuit includes:
a drive transistor;
a write transistor having a source and a drain connected between one of the data lines and one of a source and a drain of the drive transistor;
an initialization transistor having a source and a drain connected between the first initialization signal line and a gate of the drive transistor;
a light-emitting device connected to other of the source and the drain of the drive transistor;
a first reset transistor, wherein one of a source and a drain of the first reset transistor is connected to the second initialization signal line, other of the source and the drain of the first reset transistor is connected between the light-emitting device and the other of the source and the drain of the drive transistor; and
a second reset transistor, wherein a source and a drain of the second reset transistor are connected between the third initialization signal line and one of the source and drain of the drive transistor,
wherein at least one of the first initialization signal line, the second initialization signal line, and the third initialization signal line includes the shield portion.

15. The display device of claim 10, wherein the first conductive layer is located at a side of the second conductive layer away from the substrate.

16. The display device of claim 15, wherein the first conductive layer further includes a plurality of second fanout sections spaced apart from more than one of the plurality of the data lines, the plurality of second fanout sections extend in a direction across that of more than one of the plurality of first fanout sections, and one of the second fanout sections is connected to a corresponding one of the first fanout sections.

17. The display device of claim 15, wherein the display panel further includes:
a fourth conductive layer disposed between the second conductive layer and the substrate and including a scan signal line; and
a fifth conductive layer disposed between the fourth conductive layer and the second conductive layer and including an initialization signal line;
wherein the scan signal line overlaps the first fanout section, and an overlapping portion between the scan signal line and the first fanout section overlaps the initialization signal line.

18. The display device of claim 10, wherein the display panel further includes:
a first semiconductor layer disposed between the second conductive layer and the substrate and between the first conductive layer and the substrate and including polysilicon; and
a second semiconductor layer disposed between the second conductive layer and the substrate and between the first conductive layer and the substrate and located on a side of the first semiconductor layer away from the substrate and including a metal oxide.
